# EUROPEAN PATENT APPLICATION

(11) **EP 4 712 740 A1**
(43) Date of publication of application: **18.03.2026**
(21) Application number: 25179303.0
(22) Date of filing: 28.05.2025
(51) Int. Cl.: H10F 77/70, H10F 10/165, H10F 77/20

(54) **SOLAR CELL AND PHOTOVOLTAIC MODULE**

(30) Priority: 13.09.2024 CN 202411287736; 31.10.2024 CN 202411546430
(71) Applicant: Longi Solar Technology (Xi'an) Co., Ltd., Xi'an, Shaanxi 710000 (CN)
(72) Inventor: YANG, Yadi, Xi'an 710000 (CN); KANG, Lei, Xi'an 710000 (CN); LI, Dawei, Xi'an 710000 (CN); ZHAO, Zanliang, Xi'an 710000 (CN); PING, Feilin, Xi'an 710000 (CN)
(74) Representative: Pfenning, Meinig & Partner mbB

(57) **Abstract**

The present application provides a solar cell and a photovoltaic module, and relates to the field of solar cell technologies. The solar cell includes: a semiconductor substrate; a tunnel oxide layer, located on at least one surface of the semiconductor substrate; and a doped polysilicon layer, located on a surface of the tunnel oxide layer away from the semiconductor substrate. At least part of a surface of the doped polysilicon layer away from the tunnel oxide layer is provided with silicon-containing protrusion particles. The photovoltaic module provided in the present application includes the solar cell. In the present application, the silicon-containing protrusion particles are formed on at least part of the surface of the doped polysilicon layer away from the tunnel oxide layer, so as to improve a light trapping effect of at least one surface of the solar cell, thereby improving a dual-sided ratio of the solar cell.

## Description

### TECHNICAL FIELD

At least one embodiment of the present application relates to solar cells, and in particular, to a solar cell and a photovoltaic module.

### BACKGROUND

A tunnel oxide and passivation contact structure (TOPCon structure) includes an ultra-thin tunnel oxide layer and a doped polysilicon layer. The structure may be applied to various types of solar cells to form different solar cell types, for example, a TOPCon solar cell, a local TOPCon solar cell, a tunnel back-contact solar cell (TBC solar cell), or a back-contact solar cell (BC solar cell) in which one region has a TOPCon structure.

Before a high-temperature thin film depositing process is performed, a surface of a silicon substrate is polished by means of an etching process. During polishing, a tower base structure is formed on the surface of the silicon substrate. Although the tower base structure is beneficial to forming a relatively good tunnel passivation and contact after tunnel oxidation and deposition of a thin film of polysilicon, the tower base structure has a reducing effect on a light trapping effect on a surface of a solar cell. Therefore, a dual-sided ratio of the solar cell is low.

### SUMMARY

In view of this, to improve the dual-sided ratio of the solar cell, the present application provides a solar cell and a photovoltaic module.

According to embodiments of an aspect of the present application, a solar cell is provided, including: a semiconductor substrate; a tunnel oxide layer, located on at least one surface of the semiconductor substrate; and a doped polysilicon layer, located on a surface of the tunnel oxide layer away from the semiconductor substrate. At least part of a surface of the doped polysilicon layer away from the tunnel oxide layer is provided with silicon-containing protrusion particles.

According to the embodiments of the present application, at least the surface of the doped polysilicon layer located close to a corner or a side of the semiconductor substrate is provided with the silicon-containing protrusion particles.

According to the embodiments of the present application, the surface of the doped polysilicon layer away from the tunnel oxide layer is further provided with a plurality of uneven structures. A height of the silicon-containing protrusion particles is greater than a height of the uneven structures.

According to the embodiments of the present application, the doped polysilicon layer includes a plurality of first doped polysilicon layers and a plurality of second doped polysilicon layers that are alternately distributed at intervals in a first direction. One of the first doped polysilicon layers and the second doped polysilicon layers is N-type, and the other one of the first doped polysilicon layers and the second doped polysilicon layers is P-type. A surface of the first doped polysilicon layers and/or the second doped polysilicon layers is provided with the silicon-containing protrusion particles.

According to the embodiments of the present application, the at least one surface of the semiconductor substrate has a non-pyramidal texture structure. The non-pyramidal texture structure includes a plurality of sub-structures. The doped polysilicon layer on top surfaces of the sub-structures is provided with the silicon-containing protrusion particles. A distribution density of the silicon-containing protrusion particles on N-type doped polysilicon layers located on the top surfaces of the sub-structures is greater than a distribution density of the silicon-containing protrusion particles on P-type doped polysilicon layers located on the top surfaces of the sub-structures.

According to the embodiments of the present application, the at least one surface of the semiconductor substrate has a non-pyramidal texture structure. The non-pyramidal texture structure includes a plurality of sub-structures. The doped polysilicon layer on top surfaces of the sub-structures is provided with the silicon-containing protrusion particles. A distribution density of the silicon-containing protrusion particles of the doped polysilicon layer on a top surface of at least one sub-structure ranges from 0.1/um² to 0.5/um².

According to the embodiments of the present application, a quantity of the protrusion particles is less than a quantity of the uneven structures in a same cross-sectional length.

According to the embodiments of the present application, the solar cell further includes:
a passivation antireflection layer, located on a surface of the doped polysilicon layer away from the semiconductor substrate. A height of the silicon-containing protrusion particles is greater than a thickness of the passivation antireflection layer, and/or a height of the silicon-containing protrusion particles is less than three times of a thickness of the passivation antireflection layer.

In some embodiments, the doped polysilicon layer includes a plurality of first doped polysilicon layers and a plurality of second doped polysilicon layers that are alternately distributed at intervals in a first direction. One of the first doped polysilicon layers and the second doped polysilicon layers is N-type, and the other one of the first doped polysilicon layers and the second doped polysilicon layers is P-type.

At least part of the surfaces of the N-type doped polysilicon layers away from the tunnel oxide layer is provided with a plurality of pit structures, and/or at least part of the surfaces of the P-type doped polysilicon layers away from the tunnel oxide layer is provided with a plurality of pit structures.

In some embodiments, the at least one surface of the semiconductor substrate has a non-pyramidal texture structure, the non-pyramidal texture structure includes a plurality of sub-structures, the doped polysilicon layer on top surfaces of the sub-structures is provided with the pit structures, and a distribution density of the pit structures located on the top surfaces of the sub-structures ranges from 50000/mm² to 300000/mm².

In some embodiments, the at least one surface of the semiconductor substrate has a non-pyramidal texture structure, and the non-pyramidal texture structure includes a plurality of sub-structures.

At least part of the surfaces of the N-type doped polysilicon layers away from the tunnel oxide layer and on the top surfaces of the sub-structures is provided with a plurality of pit structures, and at least part of the surfaces of the P-type doped polysilicon layers away from the tunnel oxide layer and on the top surfaces of the sub-structures is provided with a plurality of pit structures.

A distribution density of the pit structures of the N-type doped polysilicon layers located on the top surfaces of the sub-structures is greater than a distribution density of the pit structures of the P-type doped polysilicon layers located on the top surfaces of the sub-structures.

In some embodiments, the solar cell further includes: a passivation antireflection layer, located on a surface of the doped polysilicon layer away from the semiconductor substrate.

The pit structures are filled with the passivation antireflection layer.

According to the embodiments of the present application, the silicon-containing protrusion particles include at least one of a C element, an N element, or an O element.

According to the embodiments of the present application, the silicon-containing protrusion particles include a IIIA element and/or a VA element.

According to the embodiments of the present application, a height of the silicon-containing protrusion particles ranges from 150 nm to 450 nm.

A length of the uneven structures in a direction parallel to the surface of the semiconductor substrate 1 ranges from 70 nm to 500 nm.

A height of the uneven structures ranges from 20 nm to 60 nm.

According to the embodiments of another aspect of the present application, a photovoltaic module is provided, including the solar cell.

According to the embodiments of the present application, the photovoltaic module includes a conductive strip. The conductive strip is applicable for electrically connecting two adjacent solar cells. In a plane direction of at least one surface of the semiconductor substrate, a gap is provided between the conductive strip and the doped polysilicon layer provided with the silicon-containing protrusion particles.

According to the solar cell provided in the embodiments of the present application, the silicon-containing protrusion particles are formed on at least part of the surface of the doped polysilicon layer away from the tunnel oxide layer, so as to improve a light trapping effect of at least one surface of the solar cell, thereby improving a dual-sided ratio of the solar cell.

### BRIEF DESCRIPTION OF THE DRAWINGS

To describe the technical solutions in the embodiments of the present application more clearly, the following briefly introduces the accompanying drawings for the embodiments. Apparently, the accompanying drawings in the following description show merely some embodiments of the present application, rather than limitations to the present application.
FIG. 1 is a schematic cross-sectional view of a back-contact solar cell according to an embodiment of the present application;
FIG. 2 is a scanning electron microscope image of a surface of a doped polysilicon layer close to an edge of a semiconductor substrate according to an embodiment of the present application;
FIG. 3 is another scanning electron microscope image of a surface of a doped polysilicon layer close to an edge of a semiconductor substrate according to an embodiment of the present application;
FIG. 4A is still another scanning electron microscope image of a surface of a doped polysilicon layer close to an edge of a semiconductor substrate according to an embodiment of the present application;
FIG. 4B is a height test diagram of the surface of the doped polysilicon layer in FIG. 4A according to an embodiment of the present application;
FIG. 5 is yet another scanning electron microscope image of a surface of a doped polysilicon layer close to an edge of a semiconductor substrate according to an embodiment of the present application;
FIG. 6 is a scanning electron microscope image of a surface of a doped polysilicon layer close to an edge of a semiconductor substrate in a side perspective according to an embodiment of the present application;
FIG. 7 is a schematic cross-sectional view of a TOPCon solar cell according to an embodiment of the present application;
FIG. 8 is still another scanning electron microscope image of a surface of a doped polysilicon layer close to an edge of a semiconductor substrate according to an embodiment of the present application;
FIG. 9A is a scanning electron microscope image of part of a region in FIG. 8; and
FIG. 9B is an EDS test result diagram of a site in FIG. 9A.

### Descriptions of reference numerals:

1-semiconductor substrate;
2-tunnel oxide layer;
3-doped polysilicon layer;
31-minority carrier region;
32-majority carrier region;
33-isolation region;
34-first doped polysilicon layer;
35-second doped polysilicon layer;
4-non-electrode collection region;
10-first electrode;
20-second electrode;
5-emitter electrode;
6-first passivation layer;
7-second passivation layer;
30-third electrode; and
40-fourth electrode.

### DETAILED DESCRIPTION

To make the objectives, technical solutions, and advantages of the present application more comprehensible, the present application is further described in detail below with reference to the embodiments and accompanying drawings. However, the present application can be implemented in different forms and should not be construed as being limited to the embodiments provided herein. On the contrary, these embodiments are provided, so that the present application can be understood more thoroughly and complete, and a scope of the present application can be completely conveyed to a person skilled in the art. In the accompanying drawings, for clarity, the sizes and relative sizes of layers and regions may be exaggerated, and the same reference numerals represent the same elements throughout the specification.

The terminology used herein is for the purpose of describing specific embodiments only and is not intended to be limiting of the present application. The terms "include" and/or "comprise" when used herein, specify the presence of stated features, steps, operations, and/or components, but do not preclude the presence or addition of one or more other features, steps, operations, or components.

In a related technology, the dual-sided ratio of the solar cell is improved from two perspectives, i.e., tower base optimization and gate line design. From the perspective of tower base optimization, a finer tower base having a larger difference between adjacent heights is prepared on a semiconductor substrate (silicon base) mainly by controlling a polishing effect. By the method, the light trapping effect on a surface of the solar cell is improved to a particular extent, but finely divided tower bases having a large height difference is apt to cause reduction of the uniformity of a subsequently deposited thin film (a tunnel oxide layer and a polysilicon layer), thereby causing tunneling, passivation, and contact problems. From the perspective of gate line design, widths of a main gate and a sub-gate are mainly narrowed. By the method, the light absorption can be improved, but an increase in a height-width ratio of the gate line imposes more requirements on the formability of a paste. In addition, a finer gate may further increase a contact resistance of solar cells.

In view of this, to solve the technical problem in the related technology that the dual-sided ratio of a solar cell urgently needs to be improved, it is necessary to provide a solar cell and a photovoltaic module.

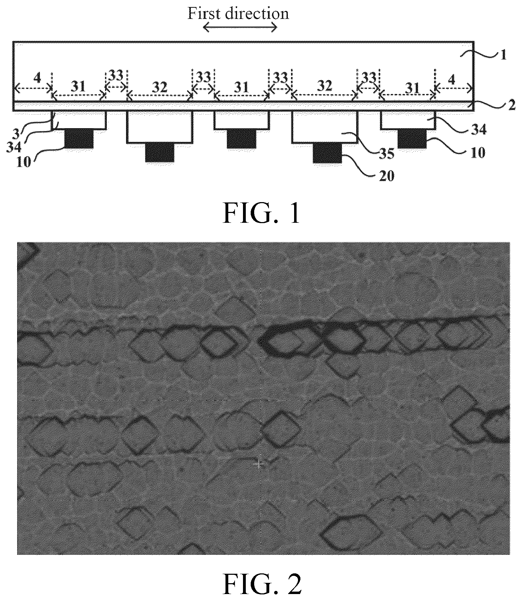

FIG. 1 is a schematic cross-sectional view of a back-contact solar cell according to an embodiment of the present application.

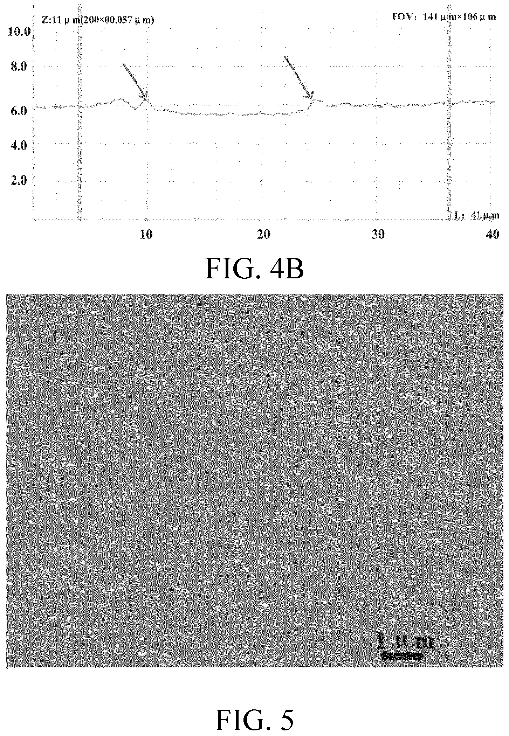

According to an exemplary embodiment of the present application, the present application provides a solar cell. Referring to FIG. 1 or FIG. 5, the solar cell includes:
a semiconductor substrate 1;
a tunnel oxide layer 2, located on at least one surface of the semiconductor substrate 1; and a doped polysilicon layer 3, located on a surface of the tunnel oxide layer 2 away from the semiconductor substrate 1. At least part of a surface of the doped polysilicon layer 3 away from the tunnel oxide layer 2 is provided with silicon-containing protrusion particles.

According to the embodiments of the present application, referring to FIG. 1, for example, the solar cell is a back-contact solar cell. The semiconductor substrate 1 has a first surface and a second surface that are opposite to each other. The tunnel oxide layer 2 is located on the second surface of the semiconductor substrate 1. In this embodiment, the second surface is a back surface of the back-contact solar cell.

In some embodiments, the surface of the doped polysilicon layer 3 away from the tunnel oxide layer 2 is further provided with a plurality of uneven structures. A height of the silicon-containing protrusion particles is greater than a height of the uneven structures.

In some embodiments, the surface of the doped polysilicon layer 3 away from the tunnel oxide layer 2 is further provided with a plurality of uneven structures. A width of the silicon-containing protrusion particles is less than a width of the uneven structures.

According to the embodiments of the present application, the uneven structures may be silicon particles. A length of the uneven structures in a direction parallel to the surface of the semiconductor substrate 1 ranges from 70 nm to 500 nm, for example, 70 nm, 100 nm, 150 nm, 200 nm, or 500 nm. A height of the uneven structures ranges from 20 nm to 60 nm, for example, 20 nm, 30 nm, 40 nm, 50 nm, or 60 nm.

According to the embodiments of the present application, the surface of the doped polysilicon layer 3 away from the tunnel oxide layer 2 has a plurality of uneven structures, the height of the uneven structures is usually relatively small, that is, ups and downs of the uneven structures are excessively slow, and therefore, it is difficult to improve the light trapping effect by means of the uneven structures, and the uneven structures have a limited contribution to the dual-sided ratio of the solar cell.

According to the embodiments of the present application, the surface of the doped polysilicon layer 3 away from the tunnel oxide layer 2 has a plurality of uneven structures, the width of the uneven structures is usually relatively large, that is, ups and downs of the uneven structures are excessively slow, and therefore, it is difficult to improve the light trapping effect by means of the uneven structures, and the uneven structures have a limited contribution to the dual-sided ratio of the solar cell. By the present application, the light trapping effect of the doped polysilicon layer is improved by means of the silicon-containing protrusion particles having a larger height and/or a smaller width, so that the dual-sided ratio of the solar cell is improved. In addition, a tunneling and passivation effect of the doped polysilicon layer is not destroyed, so that the photoelectric conversion effect of the solar cell is improved.

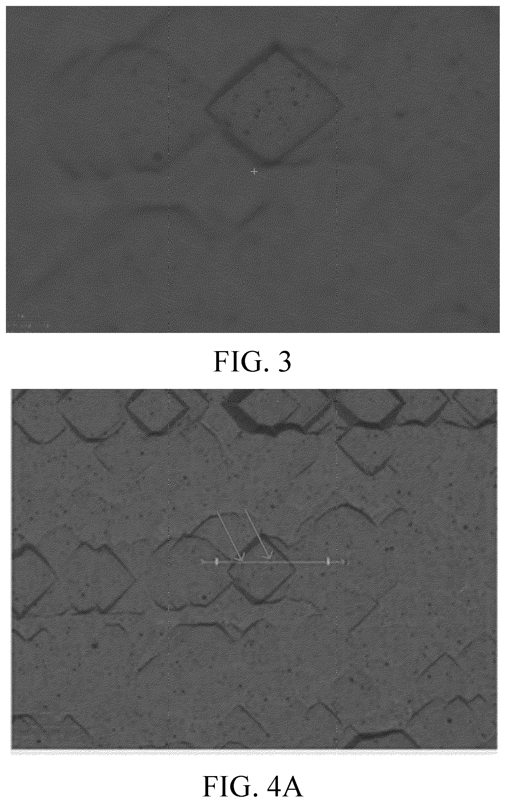

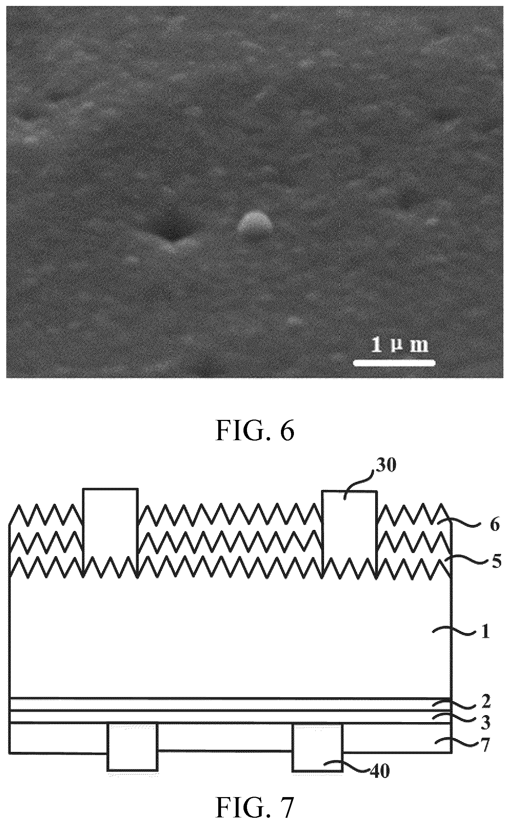

The black dots shown in FIG. 3 and white particles shown in FIG. 6 represent the silicon-containing protrusion particles. The silicon-containing protrusion particles have partial spherical structures, for example, a semispherical structure. The height (which is similar to a radius of the silicon-containing protrusion particles) of the silicon-containing protrusion particles ranges from 150 nm to 450 nm, for example, may be 150 nm, 200 nm, 300 nm, 400 nm, or 450 nm, but is not limited to the listed values.

According to the embodiments of the present application, the height of the silicon-containing protrusion particles ranges from 150 nm to 450 nm, so that a good light trapping effect can be achieved. If the height of the silicon-containing protrusion particles is excessively small, for example, less than 150 nm, sunlight cannot be refracted on the silicon-containing protrusion particles and side walls of the tower bases for a plurality of times, and it is difficult to achieve the light trapping effect. Excessively large silicon-containing protrusion particles may reduce the film forming quality of the doped polysilicon, which is not beneficial to the photoelectric conversion efficiency of the solar cell.

According to the embodiments of the present application, at least part of the surface of the doped polysilicon layer 3 of the solar cell away from the tunnel oxide layer 2 is provided with the silicon-containing protrusion particles. Referring to FIG. 4B, two height protrusions (regions pointed by arrows in FIG. 4B) on the surface of the doped polysilicon layer correspond to two silicon-containing protrusion particles (two black dots pointed by arrows in FIG. 4A) on the surface of the doped polysilicon layer in FIG. 4A. This indicates that the surface of the doped polysilicon layer away from the tunnel oxide layer is provided with the silicon-containing protrusion particles. The white dots shown in FIG. 6 are the silicon-containing protrusion particles. The height of the silicon-containing protrusion particles is greater than the height of the uneven structures, and the height of the silicon-containing protrusion particles is close to the height of pyramid structures (the height of the pyramid structures for light trapping is generally less than 1 um). Incident sunlight is refracted by the silicon-containing protrusion particles for a plurality of times, so that more sunlight is incident on the semiconductor substrate 1. The light trapping effect of the at least one surface of the solar cell is increased, thereby improving the dual-sided ratio of the solar cell.

According to the embodiments of the present application, at least the surface of the doped polysilicon layer 3 located close to a corner or a side of the semiconductor substrate 1 is provided with the silicon-containing protrusion particles.

According to the embodiments of the present application, a distance between the silicon-containing protrusion particles and an edge of the semiconductor substrate 1 is less than 3 mm, for example, may be, 1 mm, 2 mm, or 3 mm, but is not limited to the listed values.

Referring to FIG. 2, the second surface of the semiconductor substrate 1 has a non-pyramidal texture structure. The non-pyramidal texture structure includes a plurality of sub-structures (as shown by rectangles in FIG. 2). The tunnel oxide layer 2 and the doped polysilicon layer 3 are sequentially deposited on the second surface of the semiconductor substrate 1. The surface of the doped polysilicon layer 3 close to the edge of the semiconductor substrate 1 is provided with a plurality of silicon-containing protrusion particles (as shown by black dots in FIG. 2).

It should be further noted that, due to the fact that the silicon-containing protrusion particles may cause a change in a refractive index of incident light, providing an excessive amount of silicon-containing protrusion particles on an excessively large area may cause a problem of color difference of the solar cell. Specifically, the silicon-containing protrusion particles cause the surface of the doped polysilicon layer to have a higher asperity, and as a result, the doped polysilicon layer has different reflection of light of different wave lengths, thereby causing the problem of color difference of the solar cell. Therefore, by means of controlling the silicon-containing protrusion particles to be within a suitable range (the silicon-containing protrusion particles are within a range of 3 mm from the edge of the semiconductor substrate 1), not only the light trapping effect on the surface of the solar cell can be improved, but also the dual-sided ratio of the solar cell can be improved, and further, problems of flake during processing and appearance defects of a final solar cell product caused by the problem of color difference can be avoided.

According to the embodiments of the present application, referring to FIG. 1, the back-contact solar cell includes two non-electrode collection regions 4 located on the second surface of the semiconductor substrate 1, and an electrode collection region located between the two non-electrode collection regions 4. The electrode collection region includes a plurality of minority carrier regions 31 and a plurality of majority carrier regions 32 that are alternately distributed along a first direction, and an isolation region 33 is provided between the minority carrier regions 31 and the majority carrier regions 32.

According to the embodiment of the present application, the doped polysilicon layer 3 includes first doped polysilicon layers 34 and second doped polysilicon layers 35. The first doped polysilicon layers 34 for collecting and exporting minority carriers are disposed in the minority carrier regions 31. The second doped polysilicon layers 35 for collecting and exporting the majority carriers are disposed in the majority carrier regions 32. A conductivity type of the first doped polysilicon layers 34 is opposite to a conductivity type of the second doped polysilicon layers 35. One of the first doped polysilicon layers 34 and the second doped polysilicon layers 35 is N-type, and the other one of the first doped polysilicon layers 34 and the second doped polysilicon layers 35 is P-type. For example, the conductivity type of the first doped polysilicon layers 34 may be N-type. In this case, the conductivity type of the second doped polysilicon layers 35 is P-type. Alternatively, the conductivity type of the first doped polysilicon layers 34 may be P-type. In this case, the conductivity type of the second doped polysilicon layers 35 is N-type.

According to the embodiments of the present application, the semiconductor substrate 1 may be an N-type semiconductor substrate or a P-type semiconductor substrate. The conductivity type of the semiconductor substrate 1 is opposite to the conductivity type of the second doped polysilicon layers 35.

In the embodiments of the present application, for example, the semiconductor substrate 1 is N-type, the first doped polysilicon layers 34 are P-type, and the second doped polysilicon layers 35 are N-type.

According to the embodiments of the present application, the surfaces of the first doped polysilicon layers 34 and/or the second doped polysilicon layers 35 are provided with silicon-containing protrusion particles.

According to the embodiments of the present application, the surfaces of the first doped polysilicon layers 34 are provided with silicon-containing protrusion particles.

According to the embodiments of the present application, the surfaces of the second doped polysilicon layers 35 are provided with silicon-containing protrusion particles.

According to the embodiments of the present application, the surfaces of both the first doped polysilicon layers 34 and the second doped polysilicon layers 35 are provided with silicon-containing protrusion particles.

In some embodiments, at least part of the surfaces of the N-type doped polysilicon layers away from the tunnel oxide layer are provided with a plurality of protrusion structures. The effective light absorption of the N-type doped polysilicon layers can be increased by using the protrusion structures, thereby improving the dual-sided ratio of the solar cell. In addition, the contact area between the N-type doped polysilicon layers and a metal electrode can be increased by using the protrusion structures, thereby helping reduce the contact resistance. In addition, the surfaces of the P-type doped polysilicon layers away from the tunnel oxide layer are not provided with protrusion structures. The surfaces of the P-type doped polysilicon layers are flatter, helping achieve a better tunneling and passivation effect.

In some embodiments, the surfaces of the N-type doped polysilicon layers being not provided with protrusion structures may be set according to actual performance requirements of the solar cell. At least part of the surfaces of the P-type doped polysilicon layers away from the tunnel oxide layer 2 is provided with a plurality of protrusion structures. For an N-type substrate, the P-type doped polysilicon layers serve as an emitter electrode region, and the surfaces of the P-type doped polysilicon layers are provided with a plurality of protrusion structures, to increase light absorption of the P-type region, excite more carriers, improve the dual-sided ratio, and in addition further reduce the contact resistance of the P region.

According to the embodiments of the present application, surfaces of at least two first doped polysilicon layers 34 are provided with silicon-containing protrusion particles.

According to the embodiments of the present application, surfaces of the at least two second doped polysilicon layers 35 are provided with silicon-containing protrusion particles.

According to the embodiments of the present application, the surfaces of the first doped polysilicon layers 34 and/or the second doped polysilicon layers 35 are provided with silicon-containing protrusion particles. Incident light is refracted on the silicon-containing protrusion particles for a plurality of times, so that more light is injected onto the surface of the semiconductor substrate 1. Therefore, a larger quantity of the doped polysilicon layers provided with silicon-containing protrusion particles indicates that a better light trapping effect on the second surface of the solar cell can be achieved, thereby improving the dual-sided ratio of the solar cell.

According to the embodiments of the present application, the at least one surface of the semiconductor substrate 1 has a non-pyramidal texture structure. The non-pyramidal texture structure includes a plurality of sub-structures. The doped polysilicon layer on top surfaces of the sub-structures is provided with the silicon-containing protrusion particles. A distribution density of the silicon-containing protrusion particles on N-type doped polysilicon layers located on the top surfaces of the sub-structures is greater than a distribution density of the silicon-containing protrusion particles on P-type doped polysilicon layers located on the top surfaces of the sub-structures.

According to the embodiments of the present application, generally, in a process of manufacturing a back-contact solar cell, a doping concentration in N-type doped polysilicon layers is higher than a doping concentration of P-type doped polysilicon layers, and the N-type region causes a more severe Auger recombination. By means of controlling the distribution density of the silicon-containing protrusion particles on the N-type doped polysilicon layers to be greater than the distribution density of the silicon-containing protrusion particles on the P-type doped polysilicon layers, the light trapping effect of the N-type region can be enhanced, a loss of the Auger recombination is made up for, and a difference between the light trapping effects of the N-type region and the P-type region is reduced, thereby helping increase a quantity of carriers collected in the N-type region, and further improving the photoelectric conversion efficiency of the back-contact solar cell.

According to the embodiments of the present application, the at least one surface of the semiconductor substrate 1 has a non-pyramidal texture structure. The non-pyramidal texture structure includes a plurality of sub-structures. The doped polysilicon layer on top surfaces of the sub-structures is provided with the silicon-containing protrusion particles. A distribution density of the silicon-containing protrusion particles of the doped polysilicon layer on a top surface of at least one sub-structure ranges from 0.1/um² to 0.5/um². For example, the distribution density may be 0.1/um², 0.2/um², 0.3/um², 0.4/um², or 0.5/um², but is not limited to the listed values. The top surface refer to complete polygonal or complete arc structures that can be observed in a top view of a solar cell product, and corresponds to a surface which is of the silicon substrate and faces an inner recess of the silicon substrate.

According to the embodiments of the present application, a distribution quantity of the protrusion particles is less than a distribution quantity of the uneven structures in a same cross-sectional length. For example, as shown in FIG. 5, under a same magnification factor and a same window length, the distribution quantity of the uneven structures is greater than the distribution quantity of the silicon-containing protrusion particles.

It should be further noted that, the doped polysilicon layers on all of bottom surfaces, top surfaces, and side surfaces of the sub-structures of the non-pyramidal texture structure may be provided with silicon-containing protrusion particles. For ease of representation, in the present application, the top surfaces of the sub-structures are selected to quantize the distribution density of the silicon-containing protrusion particles.

According to the embodiments of the present application, the back surface of the solar cell is provided with tower base structures and silicon-containing protrusion particles. Incident sunlight is refracted on the silicon-containing protrusion particles and side walls of the tower bases for a plurality of times, so that more sunlight is injected onto the surface of the semiconductor substrate. Therefore, a doped polysilicon layers provided with denser silicon protrusion particles may further increase the light trapping effect at the back surface of the solar cell, thereby improving the dual-sided ratio of the solar cell.

In some embodiments, the plurality of pit structures are formed on at least part of the surface of the doped polysilicon layer 3 away from the tunnel oxide layer 2, so as to improve the light trapping effect of the at least one surface of the solar cell, thereby improving the dual-sided ratio of the solar cell.

At least part of the surfaces of the N-type doped polysilicon layers and/or the P-type doped polysilicon layers is provided with the plurality of pit structures. That is, at least part of surfaces of the N-type doped polysilicon layers away from the tunnel oxide layer 2 is provided with the plurality of pit structures, and surfaces of the P-type doped polysilicon layers away from the tunnel oxide layer 2 are not provided with the pit structures. Alternatively, the surfaces of the N-type doped polysilicon layers away from the tunnel oxide layer 2 are not provided with the pit structures, and at least part of surfaces of the P-type doped polysilicon layers away from the tunnel oxide layer 2 is provided with the pit structures. Alternatively, at least part of the surfaces of both the N-type doped polysilicon layers and the P-type doped polysilicon layers away from the tunnel oxide layer 2 are provided with the plurality of pit structures, and distribution densities of the pit structures included in the N-type doped polysilicon layers and the P-type doped polysilicon layers are different.

In some embodiments, a depth of the pit structures ranges from 80 nm to 150 nm, for example, may be 80 nm, 100 nm, 120 nm, 130 nm, or 150 nm, but is not limited to the listed values.

In some embodiments, referring to FIG. 5, the surface of the doped polysilicon layer close to the edge of the semiconductor substrate is provided with pit structures having a dotted or linear pit structure. A depth of the pit structures is less than a thickness of the doped polysilicon layer.

In some embodiments, a length of the pit structures in a direction parallel to the surface of the semiconductor substrate 1 ranges from 150 nm to 630 nm, for example, may be 150 nm, 200 nm, 300 nm, 500 nm, or 630 nm, but is not limited to the listed values.

According to the embodiments of the present application, the depth of the pit structures is greater than the height of the uneven structures, that is, the ups and downs of the pit structures are greater than the ups and downs of the uneven structures, and the pit structures are closer to the height of the pyramid (the height of the pyramid structure for light trapping is usually less than 1 um), thereby further improving the light trapping effect and improving the dual-sided ratio.

In some embodiments, at least part of the surfaces of the N-type doped polysilicon layers away from the tunnel oxide layer 2 is provided with a plurality of pit structures. The depth of the pit structures is greater than the height of the uneven structures. In addition, the surfaces of the P-type doped polysilicon layers away from the tunnel oxide layer 2 are not provided with pit structures.

In the embodiments of the present application, at least part of the surfaces of the N-type doped polysilicon layers away from the tunnel oxide layer is provided with the plurality of pit structures. The effective light absorption of the N-type doped polysilicon layers can be increased by using the pit structures, thereby improving the dual-sided ratio of the solar cell. In addition, the contact area between the N-type doped polysilicon layers and a metal electrode can be increased by using the pit structures, thereby helping reduce the contact resistance. In addition, the surfaces of the P-type doped polysilicon layers away from the tunnel oxide layer are not provided with pit structures. The surfaces of the P-type doped polysilicon layers are flatter, helping achieve a better tunneling and passivation effect.

For ease of representation, in the present application, the top surfaces of the sub-structures of the non-pyramidal texture structure is selected to quantize the distribution density of the pit structures.

In some embodiments, the distribution density of the pit structures on the top surfaces of the sub-structures ranges from 50000/mm² to 300000/mm², that is, the distribution density of the pit structures of the N-type doped polysilicon layers or of the pit structures of the P-type doped polysilicon layers can be selected from the foregoing range. It should be further noted that, an excessively large distribution density of the pit structures may reduce a tunneling and passivation effect of a passivation contact structure (the passivation contact structure includes a tunnel oxide layer and a doped polysilicon layer). By using an excessively small distribution density of the pit structures, and the light trapping effect cannot be fully achieved. The pit structures with the particular distribution density of the present application does not significantly reduce the tunneling and passivation effect of the passivation contact structure while achieving the light trapping effect.

In some embodiments, the surfaces of the N-type doped polysilicon layers being not provided with pit structures may be set according to actual performance requirements of the solar cell. At least part of the surfaces of the P-type doped polysilicon layers away from the tunnel oxide layer 2 is provided with the plurality of pit structures. The depth of the pit structures of the P-type doped polysilicon layers is greater than the height of the uneven structures.

According to the embodiments of the present application, for an N-type substrate, the P-type doped polysilicon layers serve as an emitter electrode region, and the surfaces of the P-type doped polysilicon layers are provided with the plurality of pit structures, to increase light absorption of the P-type region, excite more carriers, improve the dual-sided ratio, and in addition further reduce the contact resistance of the P region.

In some embodiments, at least part of the surfaces of the N-type doped polysilicon layers away from the tunnel oxide layer 2 is provided with a plurality of pit structures, and at least part of the surfaces of the P-type doped polysilicon layers away from the tunnel oxide layer 2 is also provided with a plurality of pit structures. That is, at least part of the surfaces of the N-type doped polysilicon layers on the top surfaces of the sub-structures is provided with the plurality of pit structures, and at least part of the surfaces of the P-type doped polysilicon layers on the top surfaces of the sub-structures is provided with the plurality of pit structures. A distribution density of the pit structures of the N-type doped polysilicon layers on the top surfaces of the sub-structures is greater than a distribution density of the pit structures of the P-type doped polysilicon layers on the top surfaces of the sub-structures.

In the embodiments of the present application, generally, a doping concentration in N-type doped polysilicon layers is higher than a doping concentration of P-type doped polysilicon layers, and the N-type region causes a more severe Auger recombination. By means of controlling the distribution density of the pit structures on the N-type doped polysilicon layers to be greater than the distribution density of the pit structures on the P-type doped polysilicon layers, the light trapping effect of the N-type region can be enhanced, a loss of the Auger recombination is made up for, and a difference between the light trapping effects of the N-type region and the P-type region is reduced, thereby helping increase a quantity of carriers collected in the N-type region, and further improving the photoelectric conversion efficiency of the back-contact solar cell.

In some embodiments, the solar cell further includes: a passivation antireflection layer, located on a surface of the doped polysilicon layer 3 away from the semiconductor substrate 1. A height of the silicon-containing protrusion particles is greater than a thickness of the passivation antireflection layer, and/or a height of the silicon-containing protrusion particles is less than three times of a thickness of the passivation antireflection layer.

According to the embodiments of the present application, after the passivation antireflection layer is deposited on the doped polysilicon layer 3, due to the fact that the at least part of the surface of the doped polysilicon layer 3 away from the tunnel oxide layer 2 is provided with silicon-containing protrusion particles, protrusion particles may be further formed on at least part of the surface of the passivation antireflection layer obtained through deposition.

According to the embodiments of the present application, the silicon-containing protrusion particles have a particular height, increasing a contact area with the passivation antireflection layer, further increasing an area of the passivation antireflection layer, and improving light absorption. Further, the height of the protrusion particles is less than three times of a thickness of the passivation antireflection layer. The protrusion particles are preferably not excessively high, and an excessively large height may affect the film layer uniformity of the passivation antireflection layer, thereby reducing a passivation effect.

According to the embodiments of the present application, the passivation antireflection layer includes a laminate of one or a plurality of aluminum oxide, silicon nitride, silicon oxide, or silicon oxynitride. The thickness of the passivation antireflection layer refers to a total thickness of the laminate.

For example, a thickness of the laminate of aluminum oxide/silicon nitride is 100 nm. A thickness of the aluminum oxide is 5 nm and a thickness of silicon nitride is 95 nm. A particle size of the protrusion particles ranges from approximately 300 nm to 400 nm, and a height of the protrusion particles ranges from 150 nm to 200 nm.

According to the embodiments of the present application, a passivation antireflection layer is deposited on the doped polysilicon layer, so that the pit structures of the doped polysilicon layer are filled with the passivation layer, and a surface of the passivation layer is also provided with the pit structures. In this way, the surface area of the passivation layer can be enlarged, thereby improving a passivation effect of the passivation layer. For example: the pit structures of the doped polysilicon layer are filled with a passivation antireflection layer such as an aluminum oxide/silicon nitride laminate.

According to the embodiments of the present application, the silicon-containing protrusion particles include at least one of a C element, an N element, or an O element.

According to the embodiments of the present application, the silicon-containing protrusion particles of the doped polysilicon layer have a C element and/or an N element, which can improve the flexibility of the solar cell.

According to the embodiments of the present application, the silicon-containing protrusion particles of the doped polysilicon layer have an O element, so that the electrical conduction of the doped polysilicon layer can be improved, thereby reducing the contact resistance.

According to the embodiments of the present application, the silicon-containing protrusion particles include a IIIA element and/or a VA element. A content of the IIIA element and/or the VA element of the silicon-containing protrusion particles is greater than a content of the IIIA element and/or the VA element of the corresponding tunnel oxide layer in a same doped region, and a content of the IIIA element and/or the VA element of the tunnel oxide layer corresponding to the same doped region is greater than a content of the IIIA element and/or the VA element of the semiconductor substrate corresponding to the same doped region, to further reduce contact resistance. On the basis of forming a tunneling passivation feature on the doped polysilicon layer and the tunnel oxide layer, the reduplication of photogenerated carriers on the semiconductor substrate is reduced.

According to the embodiments of the present application, the contents of the doped O element, N element, C element, IIIA element, and/or VA element are all lower than a content of the silicon element. By controlling the content of the doped element to be less than the content of the silicon element, the reduction of the service life of the minority carrier region caused by the reduplication of the photogenerated carriers and defects caused by an excessively large amount of doped element can be avoided.

According to the embodiments of the present application, the silicon-containing protrusion particles include, for example, a Si element, an N element, a C element, an O element, and a P element. A content of the Si element is 53.11 at.%, a content of the C element is 17.93 at.%, a content of the N element is 22.26 at.%, a content of the O element is 6.3 at.%, and a content of the P element is 0.4 at.%.

According to the embodiments of the present application, by introducing the C element, the O element, and the Group III A/VA element into the silicon-containing protrusion particles, the light trapping effect of the silicon-containing protrusion particles can be increased, the contact resistance can be reduced, and the photoelectric conversion efficiency of the solar cell can be improved.

According to the embodiments of the present application, the isolation regions 33 of the front surface and the back surface of the back-contact solar cell are provided with pyramid structures. The height of the silicon-containing protrusion particles is less than the height of pyramids in the isolation region 33 of the back surface of the back-contact solar cell, and is also less than the height of the pyramid structures in the front surface of the back-contact solar cell.

According to the embodiments of the present application, the surfaces of the silicon-containing protrusion particles are rough, so that the light trapping effect of the surface of the doped polysilicon layer provided with the silicon-containing protrusion particles can be further improved, thereby improving the dual-sided ratio of the solar cell.

According to the embodiments of the present application, the solar cell further includes a first electrode 10, the first electrode 10 being located on surfaces of the first doped polysilicon layers 34 away from the semiconductor substrate 1; and a second electrode 20, the second electrode 20 being located on surfaces of the second doped polysilicon layers 35 away from the semiconductor substrate 1.

According to the embodiments of the present application, under the condition that the original tower base topography and the geometrical size of the gate line are maintained, at least part of the surface of the doped polysilicon layer of the BC solar cell is provided with silicon-containing protrusion particles. In a light incident process, the incident light is refracted between the silicon-containing protrusion particles and the tower bases for a plurality of times, so that more incident light reaches the semiconductor substrate, and the light trapping effect at the back surface of the BC solar cell can be improved, thereby improving the dual-sided ratio of the BC solar cell. Passivation and contact effects of the solar cell can be maintained by keeping the original tower base and gate line features. In combination with the silicon-containing protrusion particles on the surface of the doped polysilicon layer, good passivation, contact, and light trapping effects of the BC solar cell are all achieved.

Referring to FIG. 7, according to the embodiments of the present application, the solar cell may be a dual-sided contact solar cell, for example, may be a TOPCon solar cell.

According to the embodiments of the present application, a tunnel oxide and passivation contact structure composed of the tunnel oxide layer 2 and the doped polysilicon layer 3 may be formed on at least one surface of the semiconductor substrate 1. For example, the tunnel oxide and passivation contact structure is formed on one surface or two surfaces of the semiconductor substrate 1. The tunnel oxide and passivation contact structure is formed on a local region of at least one surface of the semiconductor substrate 1. That is, the present application is further applicable to a local TOPCon solar cell (TOPCon), a TBC solar cell, or a BC solar cell having a TOPCon structure in one region, etc., provided that a TOPCon structure is provided.

According to the embodiments of the present application, referring to FIG. 7, the semiconductor substrate 1 has a first surface and a second surface that are opposite to each other, and the tunnel oxide and passivation contact structure formed by the tunnel oxide layer 2 and the doped polysilicon layer 3 is formed on the second surface of the semiconductor substrate 1.

According to the embodiments of the present application, the TOPCon solar cell further includes an emitter electrode 5 and a first passivation layer 6 that are located on the first surface of the semiconductor substrate 1; and a second passivation layer 7 located on the second surface of the semiconductor substrate 1. The first passivation layer 6 and the second passivation layer 7 implement a passivation and antireflection function.

According to the embodiments of the present application, the TOPCon solar cell further includes a third electrode 30 located on the first surface of the semiconductor substrate 1, and a fourth electrode 40 located on the second surface of the semiconductor substrate 1.

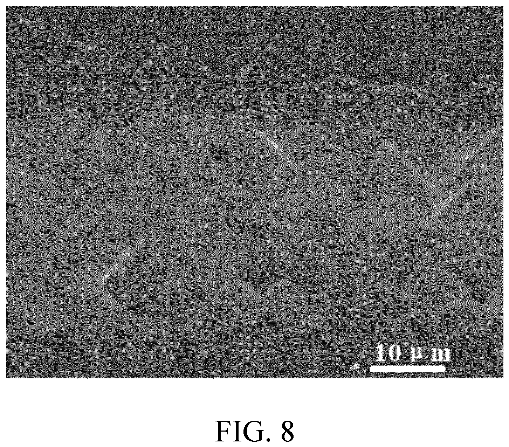

An electrode and a passivation layer of the solar cell are cleaned and removed, to expose the doped polysilicon layer under the electrode. Referring to FIG. 8, the exposed surface of the doped polysilicon layer is provided with silicon-containing protrusion particles (as shown by white dots in FIG. 8).

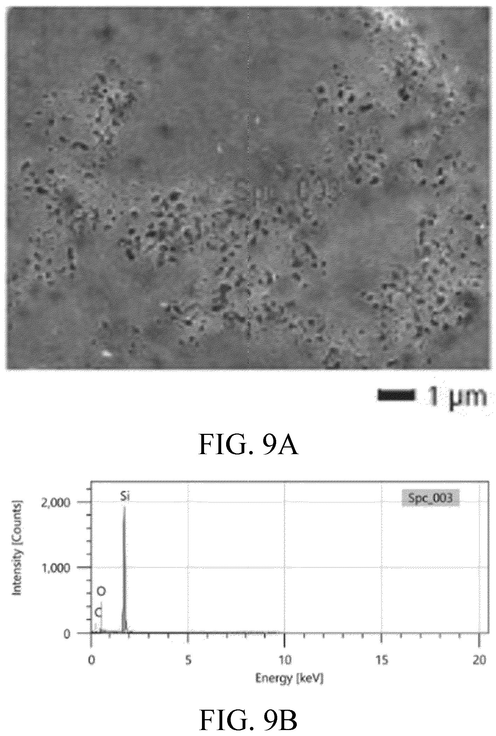

Referring to FIG. 8, FIG. 9A, and FIG. 9B, after the electrode and the passivation layer of the solar cell are cleaned and removed, it can be observed that the silicon-containing protrusion particles are retained on the surface of the doped polysilicon layer under the electrode. In addition, an EDS test is performed on any site of the doped polysilicon layer. A result of the EDS test indicates that the composition of the silicon-containing protrusion particles is silicon.

According to an exemplary embodiment of the present application, the present application provides a method for manufacturing a solar cell, including: Operation S01 to operation S03.

Operation S01: Perform polishing treatment on a semiconductor substrate 1, to obtain a semiconductor substrate 1 of which a first surface and a second surface both have tower base structures.

According to the embodiments of the present application, the polishing treatment is performed on an initial silicon sheet cut by using a diamond line, to obtain a semiconductor substrate 1 of which a first surface and a second surface both have tower base structures.

According to the embodiments of the present application, the width of the tower base structures ranges from 5 µm to 50 µm, for example, may be 5 µm, 10 µm, 20 µm, 40 µm, or 50 µm, but is not limited to the listed values. A height difference between adjacent tower bases ranges 0.2 µm to 8 µm, for example, may be 0.2 µm, 1 µm, 2 µm, 4 µm, 5 µm, 6 µm, or 8 µm, but is not limited to the listed values.

Operation S02: Deposit a tunnel oxide layer 2 on at least one surface of the semiconductor substrate 1.

According to the embodiments of the present application, the tunnel oxide layer 2 is SiO₂ having a thickness ranging from 1 nm to 5 nm.

Operation S03: Deposit a doped polysilicon layer 3 on a surface of the tunnel oxide layer 2 away from the semiconductor substrate 1, where at least part of a surface of the doped polysilicon layer 3 away from the tunnel oxide layer 2 is provided with silicon-containing protrusion particles.

According to the embodiments of the present application, a low pressure chemical vapor deposition (LPCVD) method is used to deposit the doped polysilicon layer 3. Specifically, after the tunnel oxide layer 2 is deposited, the semiconductor substrate 1 provided with tower base structures on the surface is sent to a tube oven for thin film depositing. Under conditions of a high source amount, a high temperature, and a high pressure, the doped polysilicon layer 3 provided with the silicon-containing protrusion particles on the surface is obtained.

According to the embodiments of the present application, a flow rate of silane ranges from 100 sccm to 1000 sccm, for example, may be 100 sccm, 200 sccm, 500 sccm, 800 sccm, or 1000 sccm, but is not limited to the listed values.

According to the embodiments of the present application, a depositing temperature for high-temperature thin film depositing ranges from 500°C to 700°C, for example, may be 500°C, 550°C, 600°C, 650°C, or 700°C, but is not limited to the listed values.

According to the embodiments of the present application, a pressure for the high-temperature thin film depositing ranges from 50 mTorr to 400 mTorr, for example, may be 50 mTorr, 100 mTorr, 200 mTorr, 300 mTorr, or 400 mTorr, but is not limited to the listed values.

According to the embodiments of the present application, in a thin film depositing process, when the amount of silane is sufficient, the depositing temperature is relatively high, and the depositing pressure is large, the depositing rate is relatively high. Therefore, the silane cannot instantly complete decomposition and reaction, resulting in that the continuity and uniformity of thin film depositing and growth are reduced, and after the depositing, silicon-containing particles exist in the doped polysilicon layer.

According to the embodiments of the present application, in a process of depositing the doped polysilicon layer, the depositing temperature and flow rate of a silane gas of the doped polysilicon layer located close to an edge of the semiconductor substrate are increased, so that a surface of the doped polysilicon layer located close to a corner or a side of the semiconductor substrate is provided with silicon-containing protrusion particles.

According to an exemplary embodiment of the present application, the present application provides a photovoltaic module, including the solar cell.

According to the embodiments of the present application, the silicon-containing protrusion particles are formed on at least part of the surface of the doped polysilicon layer away from the tunnel oxide layer, so as to improve the light trapping effect of the surface of the solar cell. Solar cells capable of improving the light trapping effect of the surface are manufactured into a photovoltaic module, so as to improve the dual-sided ratio of the photovoltaic module.

According to the embodiments of the present application, at least part of a surface, away from the tunnel oxide layer, of the doped polysilicon layer of the at least one energy cell in the photovoltaic module is provided with silicon-containing protrusion particles.

According to the embodiments of the present application, at least part of surfaces, away from the tunnel oxide layer, of the doped polysilicon layers of the at least two solar cells in the photovoltaic module are provided with silicon-containing protrusion particles.

According to the embodiments of the present application, the photovoltaic module includes a conductive strip. The conductive strip is applicable for electrically connecting two adjacent solar cells. On the second surface of the semiconductor substrate 1, a gap is provided between the conductive strip and the doped polysilicon layer 3 provided with the silicon-containing protrusion particles.

According to the embodiments of the present application, the conductive strip may be parallel to or perpendicular to a direction of extension of the doped polysilicon layer. The conductive strip does not shield the doped polysilicon layer provided with the silicon-containing protrusion particles, thereby not affecting improvement of the dual-sided ratio of the solar cell.

In the specification and claims, ordinal numbers such as "first", "second", and "third" used to modify corresponding elements do not mean that the elements have any ordinal number, and do not mean that a sequence of one element and another element or a sequence in a manufacturing method. Use of the ordinal numbers is merely used to clearly distinguish one element having a specific name from another element having a same name.

The foregoing specific implementations further describe the objectives, technical solutions, and beneficial effects of the present application in detail. It should be appreciated that the foregoing descriptions are merely embodiments of the present application, and are not intended to limit the protection scope of the present application. Any modification, equivalent replacement and improvement made without departing from the spirit and principle of the present application shall fall within the protection scope of the present application.

## Claims

1. A solar cell, comprising:
a semiconductor substrate (1);
a tunnel oxide layer (2), located on at least one surface of the semiconductor substrate (1); and
a doped polysilicon layer (3), located on a surface of the tunnel oxide layer (2) away from the semiconductor substrate (1),
wherein at least part of a surface of the doped polysilicon layer (3) away from the tunnel oxide layer (2) is provided with silicon-containing protrusion particles.

2. The solar cell according to claim 1, wherein
at least the surface of the doped polysilicon layer (3) located close to a corner or a side of the semiconductor substrate (1) is provided with the silicon-containing protrusion particles.

3. The solar cell according to any of claims 1 or 2, wherein the surface of the doped polysilicon layer (3) away from the tunnel oxide layer (2) is further provided with a plurality of uneven structures; and
a height of the silicon-containing protrusion particles is greater than a height of the uneven structures,
wherein a distribution quantity of the protrusion particles is preferably less than a distribution quantity of the uneven structures in a same cross-sectional length.

4. The solar cell according to any of claims 1 to 3, wherein
the doped polysilicon layer (3) comprises a plurality of first doped polysilicon layers (34) and a plurality of second doped polysilicon layers (35) that are alternately distributed at intervals in a first direction, wherein one of the first doped polysilicon layers (34) and the second doped polysilicon layers (35) is N-type, and the other one of the first doped polysilicon layers (34) and the second doped polysilicon layers (35) is P-type; and
a surface of the first doped polysilicon layers (34) and/or the second doped polysilicon layers (35) is provided with the silicon-containing protrusion particles.

5. The solar cell according to any of claims 1 to 4, wherein
the at least one surface of the semiconductor substrate (1) has a non-pyramidal texture structure, the non-pyramidal texture structure comprises a plurality of sub-structures, and the doped polysilicon layer on top surfaces of the sub-structures is provided with the silicon-containing protrusion particles; and
a distribution density of the silicon-containing protrusion particles on N-type doped polysilicon layers located on the top surfaces of the sub-structures is greater than a distribution density of the silicon-containing protrusion particles on P-type doped polysilicon layers located on the top surfaces of the sub-structures.

6. The solar cell according to any of claims 1 to 5, wherein the at least one surface of the semiconductor substrate (1) has a non-pyramidal texture structure, the non-pyramidal texture structure comprises a plurality of sub-structures, and the doped polysilicon layer on top surfaces of the sub-structures is provided with the silicon-containing protrusion particles; and
a distribution density of the silicon-containing protrusion particles of the doped polysilicon layer on a top surface of at least one sub-structure ranges from 0.1/um² to 0.5/um².

7. The solar cell according to any of claims 1 to 7, further comprising:
a passivation antireflection layer, located on a surface of the doped polysilicon layer (3) away from the semiconductor substrate (1),
wherein a height of the silicon-containing protrusion particles is greater than a thickness of the passivation antireflection layer, and/or a height of the silicon-containing protrusion particles is less than three times of a thickness of the passivation antireflection layer.

8. The solar cell according to any of claims 1 to 7, wherein the doped polysilicon layer (3) comprises a plurality of first doped polysilicon layers and a plurality of second doped polysilicon layers that are alternately distributed at intervals in a first direction, wherein one of the first doped polysilicon layers and the second doped polysilicon layers is N-type, and the other one of the first doped polysilicon layers and the second doped polysilicon layers is P-type; and
at least part of surfaces of N-type doped polysilicon layers away from the tunnel oxide layer (2) is provided with a plurality of pit structures, and/or at least part of surfaces of P-type doped polysilicon layers away from the tunnel oxide layer (2) is provided with a plurality of pit structures,
wherein the at least one surface of the semiconductor substrate (1) has preferably a non-pyramidal texture structure, the non-pyramidal texture structure comprises a plurality of sub-structures, and the doped polysilicon layer on top surfaces of the sub-structures is provided with the pit structures; and
a distribution density of the pit structures located on the top surfaces of the sub-structures ranges from 50000/mm² to 300000/mm².

9. The solar cell according to claim 8, wherein the at least one surface of the semiconductor substrate (1) has a non-pyramidal texture structure and the non-pyramidal texture structure comprises a plurality of sub-structures; and
the surfaces of the N-type doped polysilicon layers away from the tunnel oxide layer (2) on the top surfaces of at least part of the sub-structures is provided with a plurality of pit structures, and the surfaces of the P-type doped polysilicon layers away from the tunnel oxide layer (2) on the top surfaces of at least part of the sub-structures is provided with a plurality of pit structures,
wherein a distribution density of the pit structures of the N-type doped polysilicon layers located on the top surfaces of the sub-structures is greater than a distribution density of the pit structures of the P-type doped polysilicon layers located on the top surfaces of the sub-structures.

10. The solar cell according to any of claims 8 or 9, further comprising:
a passivation antireflection layer, located on a surface of the doped polysilicon layer (3) away from the semiconductor substrate (1),
the pit structures being filled with the passivation antireflection layer.

11. The solar cell according to any of claims 1 to 10, wherein the silicon-containing protrusion particles comprise at least one of a C element, an N element, or an O element.

12. The solar cell according to any of claims 1 to 11, wherein the silicon-containing protrusion particles comprise a IIIA element and/or a VA element.

13. The solar cell according to any of claims 1 to 12, wherein a height of the silicon-containing protrusion particles ranges from 150 nm to 450 nm;
a length of the uneven structures in a direction parallel to the surface of the semiconductor substrate (1) ranges from 70 nm to 500 nm; and
a height of the uneven structures ranges from 5 nm to 60 nm.

14. A photovoltaic module, comprising the solar cell according to any one of claims 1 to 13.

15. The photovoltaic module according to claim 14, wherein the photovoltaic module comprises a conductive strip, and the conductive strip is applicable for electrically connecting two adjacent solar cells; and
in a plane direction of at least one surface of the semiconductor substrate (1), a gap is provided between the conductive strip and the doped polysilicon layer (3) provided with the silicon-containing protrusion particles.
